# EUROPEAN PATENT APPLICATION

(11) **EP 0 665 467 A1**
(43) Date of publication of application: **02.08.1995**
(21) Application number: 94120902.5
(22) Date of filing: 29.12.1994
(51) Int. Cl.: G03F 7/085, G03F 7/031

(54) **Photoresist compositions with improved sensitivity and metal adhesion**

(30) Priority: 29.12.1993 US 174992
(71) Applicant: HERCULES INCORPORATED, Wilmington Delaware 19894-0001 (US)
(72) Inventor: Varnell, Daniel Felex, Wilmington, Delaware 19808 (US)
(74) Representative: Hansen, Bernd, Dr. Dipl.-Chem.

(57) **Abstract**

The invention disclosed is aqueous developable photopolymerizable photoresist compositions that have increased photosensitivity and metal adhesion by the inclusion in said compositions of a particular type of alkyl thioether oligomer, optionally being end capped with alkyl silane.

## Description

The present invention provides aqueous developable photoresist compositions having photosensitivity and metal adhesion improved by the inclusion of specific thioether oligomers.

Numerous aqueous developable photoresist compositions are disclosed in the art. As basic ingredients, conventional compositions comprise addition photopolymerizable curing material, a photoinitiator activatable by actinic radiation, a thermal polymerization inhibitor to prevent premature polymerization during storage, and a film-forming polymeric binder; usually a plasticizer is also included. The conventional photoresist compositions may also contain various other additives.

U.S. Patents Nos. 3,666,461; 3,661,575; and 4,120,721 disclose aqueous curable photoresist compositions. These contain a photocurable composition formed from a particular polyene complex and an organic material containing active hydrogen groups, preferably polythiols having pendent, or terminally positioned, - SH groups. These photoresist compositions containing -SH end groups have not been totally acceptable because of the odor of the -SH groups, and because the -SH groups tend to complex with copper substrates forming a hazardous waste requiring expensive disposal.

U.S. Patent 3,844,790; DE 2,602,409; BE 850,623; and BE 837,489 describe the use of certain compounds, particularly heterocyclic mercaptans, to accelerate curing. Compounds relating to the present thioethers as curing enhancers are not disclosed.

U.S. Patent No. 4,686,171 discloses aqueous developable photoresist composition having included therein additives of siliceous material and plasticizer to increase product flexibility and reduce cold flow. No additives for improved photosensitivity are disclosed. The numerous photoresist compositions, with and without the aforementioned additives, are said to be useful in the preparation of the compositions of the present invention.

An important requirement for aqueous developable photoresist compositions is high photosensitivity. Photosensitivity is the extent of cure (insolubilizing polymerization) of the photopolymerizable component for a given exposure to actinic radiation, such as UV. Said another way, photosensitivity is the intensity of actinic light for a fixed time required to obtain the minimum level of cure required so that cured resist does not wash off during developing. The sensitivity can be measured using a sensitometric step tablet, such as a Stouffer Graphic Arts Step Sensitivity Guide. The total level of cure is a function of exposure time, optical density of the step light, and the photosensitivity of the photoresist material film. For equivalent exposure times and optical densities of the light, the magnitude of the Stouffer step level, through which the desired operational cure is obtained, is a direct measure of sensitivity. The higher the Stouffer step number, the greater the sensitivity of the photoresist film (giving a predetermined level of cure). Hereinafter, Stouffer step numbers are used to measure the sensitivity of photoresist films.

It has been found that the inclusion in conventional aqueous developable photoresist compositions of certain thioether oligomers will greatly increase the photosensitivity of the photoresist composition. Accordingly, this invention relates to aqueous developable photoresist compositions of increased sensitivity, to the process of their preparation, and to the process for curing such compositions.

In accordance with the present invention, it has been found that the inclusion in conventional aqueous developable photoresist compositions of certain thioether oligomers will greatly increase the photosensitivity of the photoresist compositions. Increases of from 30 to 100% have been observed. Due to this increased photosensitivity, photoresist plates coated with the compositions of the present invention can be processed faster, with clearer definition of image, and with less danger of wash off of cured areas during developing than conventional compositions. The inclusion of thioether oligomer also improves adherence of the composition to the metal base plate, normally copper.

The thioether oligomers found useful as sensitivity-enhancing additives to conventional curable photoresist compositions are random oligomers represented by the formula: 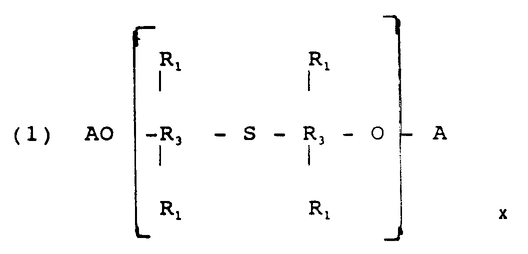
wherein the end-cap "A"s the same or different and are selected from the group consisting of -H and -Si (R₂)₃, wherein R₂ are the same or different and are linear or branched alkyls; R₁ are the same or different and are selected from the group consisting of -H and linear or branched alkyls; wherein R₃ are the same or different and are linear alkyls having from 2 to 4 carbons, preferably 2 carbons and X equals an average number that gives the oligomer, or copolymer, a weight average molecular weight of 10,000 g/mol. or less, preferably 8,000 g/mol. or less; or greater than about 300 g/mol., preferably greater than about 500 g/mol.; or in the range of about 300 to 10,000 g/mol., preferably in the range of about 500 to 8,000 g/mol.

In the preferred oligomers, R₁ are -H or alkyls of 1 to 12 carbon atoms, more preferably -H and methyls; and R₂ are alkyls of 1 to 12 carbon atoms, more preferably methyls.

The thioether oligomers found most useful as sensitivity-enhancing additives to conventional aqueous curable photoresist compositions are random oligomers of (CH₂ CH₂S CH₂ CH₂O) and (CH₂ CH₂S CH₂ CH-O) end-capped with -H or trialkyl silane and CH₃ are represented by the formula: 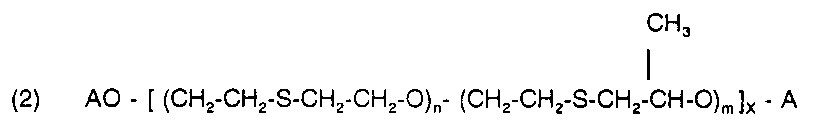
wherein (n) and (m) are the same or different and are whole integers of 0 to 10 where the sum of m + n equals 10; and the end-capping "A"s are as defined in formula (1).

In the most preferred oligomers of formula (2), "A"s consist essentially of hydrogen. The thioether oligomers, having a molecular weight of 300 to 10,000g/mole, can replace part or all of the plasticizer in the compositions.

For best effectiveness, the thioether oligomer is present in the resist composition in an amount by weight of about 1% to 20%, preferably about 1% to 10% The greater percentages give greater sensitivity enhancement up to about 20%, but sensitivity increase per unit of oligomer added decreases progressively above about 10%. The exception to this is when the actinic radiation is laser; better sensitivity is obtained when about 10% to 20% of oligomer is present when laser radiation is the actinic radiation. Those experienced in the art can readily balance improved photospeed, plasticity, flexibility and other properties to obtain the desired combination of properties for a particular use.

The photoresist composition may be a pourable liquid or completely in solution (solvated), or it may be solid, usually as a sheet material.

As aforementioned, the present invention is based on the inclusion of Formula (1) thioether oligomers into aqueous developable photocurable resist compositions to enhance their photosensitivity. These thioether oligomer photosensitivity enhancers are in general effective in aqueous developable actinic radiation curable products that rely on free radical crosslinking for curing.

The actinic radiation employed usually is from any conventional source of U.V. light. Under some circumstances, it is desirable to use U.V. laser actinic radiation to cure the resist compositions of the present invention. As aforementioned, when U.V. laser radiation is used, better results are obtained in the resist compositions containing the higher percentages of thioether oligomer, preferably about 10% to 20%.

Thus, these thioether photosensitivity enhancers are effective in dry-film primary image resists, laser direct image resists, dry-film solder masks, liquid dry film resists, liquid solder masks (meaning the solder composition is liquid when applied to the substrate), photo curable films for electroforming, chemical milling and other related uses. For most uses, the photoresist composition is sandwiched between a support member, such as a copper surfaced plate, and a cover member, such as a removable protective plastic film.

As aforementioned, conventional photoresist compositions useful in the preparation of the thioether oligomer photosensitivity - enhanced compositions of the present invention comprise an addition photopolymerizable material, a free-radical photoinitiator, a thermal polymerization inhibitor, and a film-forming polymeric binder

Based on weight, typical conventional aqueous photoresist compositions contain about 5 to 40 parts per hundred parts of composition of photopolymerizable material, 1 to 10 parts of photoinitiator, .003 to 1 parts of polymerization inhibitor and 30 to 70 parts of binder. To this or other conventional aqueous photoresist composition is added about 1% to 20% by weight or more of the formula (1) thioether oligomer composition to produce the sensitivity-enhanced compositions of the present invention. Optionally, 5 to 20 parts of a plasticizer may be added to the composition of the present invention.

The polyfunctional addition photopolymerizable materials which find application in the subject invention are essentially non-gaseous, contain at least 2, preferably 2 to 4, more preferably 2 to 3 ethylenic double bonds. Having at least 2 ethylenic double bonds makes the monomer polyfunctional, i.e., capable of cross-linked polymerization. Examples of useful polyfunctional addition photopolymerizable materials are found in U. S. Patent No. 4,686,171. Suitable monomers include alkylene or polyalkylene glycol diacrylates. Monomers containing vinylidene groups conjugated with ester linkages are particularly suitable. Illustrative examples include, but are not limited to, ethylene diacrylate; diethylene glycol diacrylate; glycerol diacrylate; glycerol triacrylate; 1,3-propanediol dimethacrylate; 1,2,4-butanetriol trimethacrylate; 1,4-benzenediol dimethacrylate; 1,4-cyclohexanediol diacrylate; pentaerythritol tri- and tetramethacrylate; pentaerythritol tri- and tetraacrylate; tetraethylene glycol dimethacrylate; trimethylolpropane trimethacrylate; triethylene glycol diacrylate; tetraethylene glycol diacrylate; pentaerythritol triacrylate; trimethylel propane triacrylate; pentaerythritol tetraacrylate; 1,3-propanediol diacrylate; 1,5-pentanediol dimethacrylate; and the bis-acrylates and bis-methacrylates of polyethylene glycols, polypropylene glycols, and copolymers thereof of molecular weight from about 100 to about 500 (number of average). Other useful photopolymerizable materials will be apparent to those skilled in the art.

The free-radical photoinitiator is a conventional photoinitiator activatable by actinic radiation that is thermally inactive below about 185°C. Examples of useful photoinitiators are found in U.S. Patent No. 4,268,610. Preferable photoinitiators are aromatic ketones, such as benzophenone. Other useful photoinitiators will be apparent to those skilled in the art.

The thermal polymerization inhibitor prevents thermal polymerization during drying and storage. Examples of useful thermal polymerization inhibitors are found in U. S. Patent No. 4,686,171. Examples of preferred thermal polymerization inhibitors are p-methoxyphenol, hydroquinone, alkyl and aryl-substituted hydroquinones and quinones, tertbutyl catechol, pyrogallol, copper resinate, B-naphthol, 2,6-di-tert-butyl-p-cresol, 2,2-methylene-bis(4-ethyl-6-t-butylphenol), p-tolylquinone, chloranil, aryl phosphites, and aryl alkyl phosphites. Other useful thermal polymerization inhibitors will be apparent to those skilled in the art.

The preferred film-forming polymeric binder is prepared from one or more film-forming, vinyl type monomers and one or more alpha, beta ethylenically unsaturated carboxyl group containing monomers having 3-15 carbon atoms, which makes the binder soluble in aqueous media. Examples of useful vinyl type monomers are alkyl and hydroxyalkyl acrylates and methacrylates having 3-15 carbon atoms, styrene, and alkyl substituted styrenes. The acrylates and methacrylates are preferred. Examples of useful carboxyl group-containing monomers are cinnamic acid, crotonic acid, sorbic acid, acrylic acid, methacrylic acid, itaconic acid, propiolic acid, maleic acid, fumaric acid, and half esters and anhydrides of these acids. Acrylic acid and methacrylic acid are preferred. Examples of useful binders are found in U.S. Patent No. 4,539,286. Other useful binders will be apparent to those skilled in the art.

In manufacture, a photopolymerizable material is included in the photoresist composition of the instant invention. Based on the weight of the total photoresist composition of the instant invention, the amount of the additional photopolymerizable material used is about 20% or less, preferably 10% or less more preferably 6% or less, or in a range of 1% to 20%, preferably from about 1.5% to about 10%, more preferably from about 2.0% to about 6%. A monofunctional (i.e., containing one ethylenic double bond) carboxyl group containing monomer is preferably used in these compositions because the photopolymerized material made from the photopolymerizable composition is then strippable from a substrate in small pieces, while without this monomer, the photopolymerized material strips well, but in large sheets. Stripping in small pieces is preferred since the photopolymerized material between fine lines is more easily removed. Also, some stripping apparatuses have filtration systems that could have clogging problems if stripping occurs in large sheets. Useful monofunctional carboxyl group-containing addition photopolymerizable monomers are, for example, itaconic acid, betacarboxyethylacrylate, citraconic acid, crotonic acid, monomethacryloyloxyethyl phthalate, monoacryoyloxyethyl phthalate, and fumaric acid. Itaconic acid and beta-carboxyethylacrylate are preferred. Other useful monomers will be apparent to those skilled in the art.

The photoresist composition of this invention optionally includes additives well known in the art of photopolymerizable compositions, such as leuco (i.e., printout) dyes, background dyes, adhesion promoters, and antioxidants as disclosed in U.S. Patent No. 4,297,435, and the heretofore mentioned U.S. Patent No. 4,268,610. Other optional additives will be apparent to those skilled in the art. While desirable, the optional additives are not essential to the instant invention.

The photopolymerizable composition of this invention is prepared by mixing the various components in a solvent. Mixing must be sufficient to evenly disperse the materials throughout the mixture. Suitable solvents are alcohols, ketones, halogenated hydrocarbons, and ethers. Other solvents will be apparent to those skilled in the art. After mixing, the composition is then coated onto a support, and the solvent is evaporated. U.S. Patent Nos. 3,469,982 and 4,293,635 disclose useful methods for preparing the photopolymerizable composition of this invention, i.e., as rolls of dry film sandwiched between a flexible support member and a flexible cover member. It will be apparent to those skilled in the art that dry films of the instant invention can be made on inflexible supports as well as flexible supports and may be supplied as stacks of laminated sheets as disclosed in the heretofore mentioned U.S. Patent No. 4,268,610, as well as rolls.

In a preferred embodiment, the photopolymerizable composition of this invention is used as a photoresist in the manufacture of printed circuit boards. Generally, the composition is coated onto the copper surface of a copper clad substrate, exposed to actinic radiation through a negative to cure and create a latent image of photopolymerized material, and developed in a known aqueous developing solution to remove the unpolymerized composition from the copper surface. The portions of the surface not covered by the photopolymerized material are then modifiable by known processes, e.g., by plating or etching procedures, while the photoresist protects the covered surface. The photopolymerized material can be ultimately removed from the substrate by washing with known stripping solutions.

The photopolymerizable composition of the instant invention is applied to the copper clad substrate by known procedures, such as hot shoe or hot roll lamination of the dry film attached to a transparent, peelable support, which support is removed after polymerization, as disclosed in the heretofore mentioned U.S. Patent No. 4,293,635. Generally, the amount of actinic radiation used to polymerize the composition varies from about 35 to about 150 mJ/cm2, with precise amounts determinable by those skilled in the art based on the specific composition used.

The copper clad substrate is any known copper, dielectric laminate used in circuit board manufacture, such as a copper clad board of fiberglass reinforced epoxy resin. Other useful dielectrics will be apparent to those skilled in the art.

The aqueous developing solutions used in accordance with this invention have, by weight, about 0.5% to 2.0% alkaline agents, preferably about 0.5% to 1%. The latent photopolymerizable material is washed in the solution for a time sufficient to remove the unpolymerized composition. Useful alkaline agents are alkali metal hydroxides, e.g., lithium, sodium and potassium hydroxide, the base reacting alkali metal salts of weak acids, e.g., sodium carbonate and bicarbonate, and alkali metal phosphates and pyro-phosphates. Sodium carbonate is preferred. The circuit board can be submerged in the developing solution or, preferably, the solution is high pressure sprayed on the board.

In general, the stripping solutions useful in removing the photopolymerized material in accordance with the instant invention are heated aqueous alkaline solutions, using the same alkaline agents as the developing solutions, but having a higher alkaline concentration, i.e., generally, by weight, from about 1% to 10%, preferably from about 1% to 3%. Generally, the stripping solution is heated to a temperature of about 45°C-65°C, preferably about 50°C-55°C. Washing the substrate to remove the photopolymerized material is by methods well known to those skilled in the art, such as spraying the substrate with the heated stripping solution, or, preferably, agitating the substrate in a heated bath of the stripping solution.

Examples of the photoimaging techniques and equipment, including radiation sources, exposure intensity and duration, developing and stripping solutions and techniques, and laminated board composition useful in the preferred embodiment are disclosed in the heretofore described U.S. Patent Nos. 3,469,982, 4,293,635, and 4,268,610.

Of course, it will be apparent that the composition of the instant invention is useful in solvated form. For example, in silk screen printing techniques for circuit board manufacture, the composition of the instant invention is applied to circuit boards in solvated form. Screen printing techniques are disclosed in Printed Circuit Handbook, 2nd edition, ed. by Clyde F. Coombs, Jr., (1979). Also, in photoimaging techniques as described in the preferred embodiment herein, the composition can be coated onto the substrate in solvated form, and the solvent then evaporated.

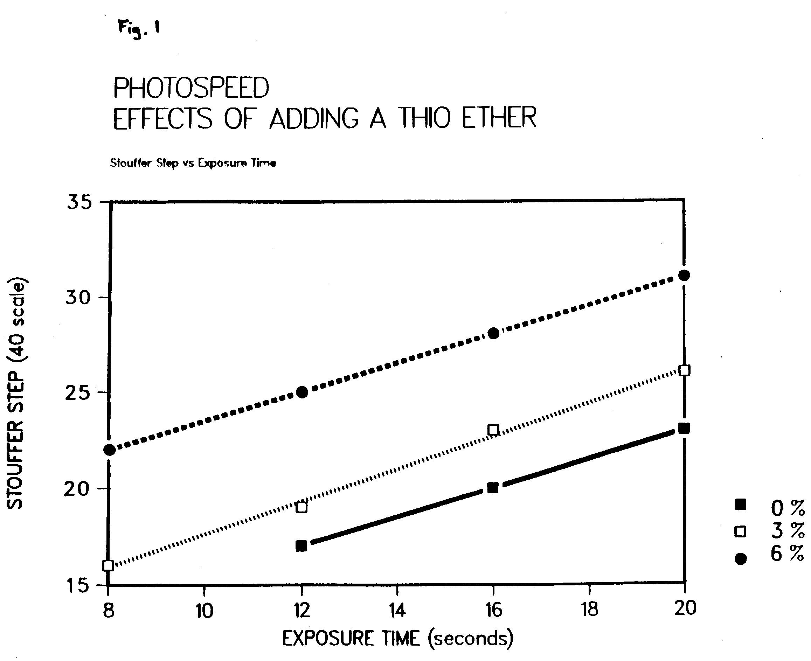

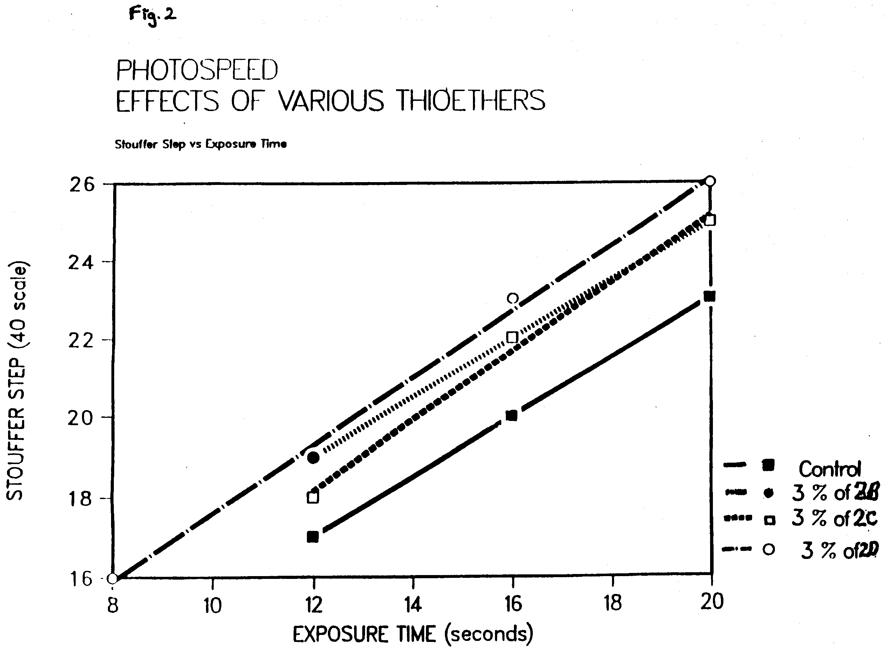

In the drawings, Figure 1 is a graph relating to Example 1 showing the effect on photosensitivity of the inclusion of different amounts of a preferred present invention thioether oligomer in a conventional aqueous developable photoresist composition. Figure 2 is a graph relating to Example 2 showing the comparative effects on photosensitivity of the inclusion of several different thioether oligomers of the present invention.

To more adequately describe the invention, the following Examples and Controls are included. However, the instant invention is not intended to be limited thereby. All parts and percentages in the Examples and Controls are by weight unless otherwise indicated.

This example shows the relative effectiveness of different quantities of a preferred hydroxyl terminated thioether random oligomer of the present invention in a conventional photoresist composition used for imaging in the manufacture of printed boards. The oligomer can be represented by the following formula: 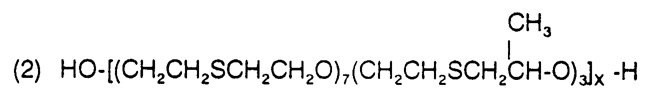
wherein x expresses the average chain length of a mixture of oligiomers that gives the oligomer a molecular weight of about 500g/mole. The amount of oligomer present is listed in percent by weight of the composition, not including the oligomer.

Table I lists the ratio of ingredients (other than thioether) of the three resist formulations of this example in parts by weight; 1A, 1B and 1C.

**TABLE 1**

| Component | 1A | 1B | 1C |
|---|---|---|---|
| Acrylic Polymer* | 73.2 | 70.2 | 67.2 |
| Thioether | 0 | 3.0 | 6.0 |
| Trimethylol propane triacrylate | 10.5 | 10.5 | 10.5 |
| Triethylene glycol dimethacrylate | 10.5 | 10.5 | 10.5 |
| Benzophenone | 5.5 | 5.5 | 5.5 |
| Michlers Ketone | .25 | .25 | .25 |
| Butylated Hydroxy Toluene | .017 | .017 | .017 |

| | | | |
|---|---|---|---|
| * The acrylic polymer binder is a terpolymer of 45% methyl acrylate, 40% ethyl acrylate and 15% methacrylic acid. It is synthesized as follows. A reaction vessel is charged with 422g methyl ethyl ketone and 555g of the monomer mixture composed of 45% methyl methacrylate, 40% ethyl acrylate and 15% methacrylate acid. While under a nitrogen atmosphere, the contents are stirred for about one hour while heating at about 80°C. The vessel is then charged with 7ml of a solution having a concentration of 0.05g azobisisobutyronitrile per 1ml of methyl ethyl ketone. After 5 hours, 19ml of a solution having a concentration of 0.05g of azobisisobutyronitrile per 1ml methyl ethyl ketone are added, and the polymerization allowed to continue for an additional nine hours. After the polymerization is complete, the binder is placed in a glass container and methyl ethyl ketone added to bring the polymer solids content to 31%. | | | |

For each composition, the ingredients were combined with an equal amount of methyl ethyl ketone and mixed thoroughly using a mechanical stirrer at room temperature at 1000 rpm.

Films from each sample were cast onto polyester film using a doctor blade to control thickness. The films were placed in an oven at 68-100°C (55-212°F) to remove the solvent. The dry photoresist films had a thickness of approximately .0015 inches (40 micrometers).

Samples of each film were laminated to scrubbed copper laminate panels with a hot shoe laminator at 113°C at 1.22m per minute (235°F at 4 feet per minute). The polyester film was left in place as a protective cover film. This photopolymerizable element is a photopolymerizable composition sandwiched between a support member and a cover member.

The samples were then exposed to U.V. radiation from a medium pressure mercury lamp through a photo tool including a 40 step Stouffer step table. Following exposure, the polyester film was removed, and the films were developed in an aqueous 0.75% sodium carbonate solution at 29°C (85°F). The time in seconds and the amount of U.V. exposure was measured by the Stouffer step table number for a fixed degree of curing.

The results of these exposure tests are listed in Table 2 and are shown graphically in Figure 1. The results are listed as the Stouffer step number versus a required exposure time for a fixed degree of curing.

**TABLE 2**

| Sample # | % Thioether | Exposure (seconds) | Stouffer Step |
|---|---|---|---|
| 1A (control) | 0 | 12 | 17 |
| | | 16 | 20 |
| | | 20 | 25 |
| 1B | 3 | 8 | 16 |
| | | 12 | 19 |
| | | 16 | 23 |
| | | 20 | 26 |
| 1C | 6 | 8 | 22 |
| | | 12 | 25 |
| | | 16 | 28 |
| | | 20 | 31 |

This example shows the effectiveness of two other present invention thioether oligomers with much higher molecular weight. One is end-capped with trimethyl silane. Included in Table 2 is Example 2B which is Sample 1B in Example I (hydroxyl terminated, 500 molecular weight). Each of the compositions of Table 2 contained the parts by weight as in Example I of trimethylol propane triacrylate, triethylene glycol dimethacrylate, benzophenone, Michlers Ketone, and butylated hydroxy toluene.

Sample 2A (control) contained no thioether. All other samples contained 3% thioether. Sample 2B (same as 1B) was hydroxyl terminated and had a weight average molecular weight of 500 g/mole. Sample 2C contained a hydroxyl terminated thioether, with n=7 and m=3, and had a weight average molecular weight of 3200 g/mole. In the Sample 2D thioether, n=7 and m=3, but it was terminated with the "A"s being trimethyl siloxane and had a weight average molecular weight of 6000 g/mole.

**TABLE 3**

| Component | 2A | 2B | 2C | 2D |
|---|---|---|---|---|
| Acrylic Polymer of Table 1 | 73.2 parts | 70.2 parts | 70.2 parts | 70.2 parts |
| Thioether | 0% | 3.0% | 3.0% | 3.0% |

The samples were processed and tested as in Example 1. The results of these tests are listed in Table 4 and shown graphically in Figure 2.

**TABLE 4**

| Sample # | Exposure (seconds) | Stouffer Step |
|---|---|---|
| 2A (control) | 12 | 17 |
| | 16 | 20 |
| | 20 | 23 |
| 2B | 8 | 16 |
| | 12 | 19 |
| | 16 | 23 |
| | 20 | 26 |
| 2C | 12 | 19 |
| | 16 | 22 |
| | 20 | 25 |
| 2D | 12 | 18 |
| | 16 | 22 |
| | 20 | 25 |

## Claims

1. An aqueous developable photopolymerizable composition, wherein said composition comprises a random oligomer of 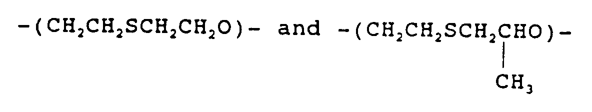 end capped with -H or alkyl silane and having a weight average molecular weight of about 10,000 g/mol. or less.

2. The aqueous developable photopolymerizable composition of claim 1 wherein said composition has a weight average molecular weight greater than about 300 g/mol.

3. The aqueous developable photopolymerizable composition of claim 1 wherein said composition has a weight average molecular weight in the range of about 500 to 8,000 g/mol, and wherein said oligomer comprises about 1% to 20% by weight of the total photopolymerizable composition.

4. An aqueous developable photopolymerizable composition,
wherein said composition comprises oligomer of the formula: 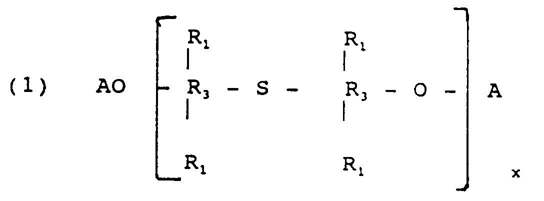 wherein the end-cap "A"s are the same or different and are selected from the group consisting of -H and -Si (R₂)₃, wherein R₂ are the same or different and are linear or branched alkyls; R₁ are the same or different and are selected from the group consisting of -H and linear or branched alkyls; wherein R₃ are the same or different and are linear alkyls having from 2 to 4 carbons; and X equals an average number that gives the oligomer a weight average molecular weight of about 10,000 g/mol. or less.

5. The composition of Claim 4 wherein R₁ are selected from the group consisting of alkyls and -H, and R₂ are alkyls of 1 to 12 carbon atoms, or wherein R₁ are selected from the group consisting of alkyls of 1 to 12 carbon atoms and - H, and R₂ are methyls.

6. The composition of Claim 4 wherein said oligomer is represented by the formula: 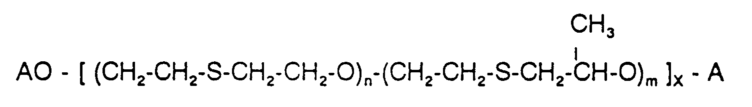 wherein (n) and (m) are the same or different and are whole integers of 0 to 10 where the sum of m + n equals 10; X equals an average number that gives the oligomer a weight average molecular weight of 300-10,000 g/mole; and "A"s are selected from the group consisting of -H and -Si(R₂) where the R₂'s are the same or different and are alkyls.

7. The composition of any one of Claims 1 to 6 wherein said photopolymerizable composition comprises, in addition to said oligomer, by weight ratio about 5 to 40 parts of photopolymerizable material, 1 to 10 parts of photoinitiator, .003 to 1 parts of polymerization inhibitor, and 30 to 70 parts of binder.

8. The process of increasing the sensitivity of an aqueous developable photopolymerizable composition comprising including therein, as a photosensitivity enhancer, an oligomer of Claims 1 to 7.

9. The process of manufacturing printed circuit boards comprising the steps of:
coating onto a copper surface of a copper clad substrate a composition comprising an aqueous developable photopolymerizable composition, wherein said composition comprises oligomer of the formula: 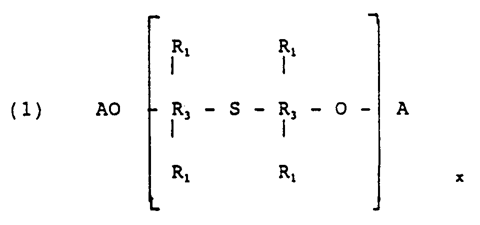 wherein the end-cap "A"s are the same or different and are selected from the group consisting of -H and -Si (R₂)₃, wherein R₂ are the same or different and are linear or branched alkyls; R₁ are the same or different and are selected from the group consisting of -H and linear or branched alkyls; wherein R₃ are the same or different and are linear alkyls having from 2 to 4 carbons; and X equals an average number that gives the oligomer a weight average molecular weight of 10,000 g/mol. or less;
exposing the aqueous developable photopolymerizable composition to actinic radiation through a negative to cure and create a latent image of photopolymerized material; and
developing in an aqueous developing solution to remove unpolymerized composition from the copper surface.
